**Europäisches Patentamt**

**European Patent Office**

**Office européen des brevets**

(19)

(11) Veröffentlichungsnummer: **0 060 319**
**B1**

(12) # EUROPÄISCHE PATENTSCHRIFT

(45) Veröffentlichungstag der Patentschrift :
28.08.85

(51) Int. Cl.⁴ : **G 01 R 27/26**

(21) Anmeldenummer : **81108234.6**

(22) Anmeldetag : **12.10.81**

(54) **Verfahren und Vorrichtung zur Messung der Kapazitäten an einem kapazitiven Schutzzaun.**

(30) Priorität : **17.03.81 DE 3110352**

(43) Veröffentlichungstag der Anmeldung :
**22.09.82 Patentblatt 82/38**

(45) Bekanntmachung des Hinweises auf die Patenterteilung : **28.08.85 Patentblatt 85/35**

(84) Benannte Vertragsstaaten :
**AT BE CH IT LI NL**

(56) Entgegenhaltungen :
DE-A- 2 539 501
US-A- 3 843 924
ENTWICKLUNGSBERICHTE DER SIEMENS-HALSKE WERKE, Band 30, no. 2, Juli 1967 A. RECHTEN "Untersuchung an Elektrodensysteme für den Kapazitiven Raumschutz", Seiten 177/184
SIEMENS ZEITSCHRIFT, Heft 4, April 1962 J. SCHÖNE "Elektrodenanordnungen bei Feldraumschutzanlagen"

(73) Patentinhaber : **Siemens Aktiengesellschaft Berlin und München Wittelsbacherplatz 2 D-8000 München 2 (DE)**

(72) Erfinder : **Metzner, Uwe Theodolindenstrasse 49 D-8000 München 90 (DE)**
Erfinder : **Thilo, Peer, Dr.Ing. Buchhierlstrasse 19 D-8000 München 71 (DE)**

## Beschreibung

Die Erfindung betrifft ein Verfahren zur Messung der Kapazitäten an einem kapazitivem Schutzzaun gemäß dem Oberbegriff des Anspruchs 1 und eine Einrichtung zur Durchführung des Verfahrens.

Für einen sicheren Objektschutz wird häufig zusätzlich zum Gebäudeschutz die Umgebung beispielsweise mit einem Schutzzaun abgesichert. Damit soll ein unbefugtes Eindringen verhindert, zumindest aber erschwert werden. Um ein unbefugtes Eindringen zu erkennen, werden kapazitive Schutzzäune, die bei einem Annähern oder bei einem Durchdringen seitens eines Eindringlings einen Alarm auslösen, errichtet. Besonders überwachungsbedürftige und gefährdete Objekte, z. B. Kernkraftwerke, militärische Anlagen, bedürfen einer äußerst sicheren Raumschutzanlage.

Solche Raumschutzanlagen, insbesondere Freilandanlagen, sind gewissen störenden Umwelteinflüssen ausgesetzt, so daß die Störempfindlichkeit verhältnismäßig groß ist und häufig Fehlalarme ausgelöst werden. Raumschutzanlagen müssen daher so aufgebaut sein, daß die anzuzeigenden Effekte sicher, Störungen jedoch nicht zum Alarm führen.

Störende Umwelteinflüsse können beispielsweise Drahtverdickungen durch Regen oder Rauhreif, Verschiebung der Erdfläche durch Schnee und Feuchtigkeit, oder Drahtauslenkungen durch Wind und sich im elektrostatischen Feld bewegende Teile, z. B. Umfassungszäune, sein.

Üblicherweise werden die Teilkapazitäten zwischen Sende- und Empfangselektroden gemessen und über eine Differentialbrücke die resultierende Differenz dieser Teilkapazität ausgewertet (z. B. DE-C-1 220 289). Dadurch können symmetrisch auftretende Umwelteinflüsse eliminiert werden. Aus dieser resultierenden Kapazitätsdifferenz wird ein Alarm abgeleitet. Dabei wird entweder durch eine sprunghafte Kapazitätsänderung einer bestimmten Größe oder durch eine stetige Kapazitätsänderung mit definierter Änderungsgeschwindigkeit ein Alarm ausgelöst. Diese relativ einfachen Alarmkriterien bedingen aber auch eine geringe Störsicherheit. Um einen Eindringling sicher erkennen zu können, kann man bei einer derartigen Anlage die Ansprechempfindlichkeit erhöhen. Dies bringt aber im allgemeinen mit sich, daß die Störempfindlichkeit auch größer wird, d. h. die Störsicherheit erniedrigt sich.

Aus der DE-A-25 39 501 ist eine Anlage zur Überwachung von Objekten in Form von Gegenständen oder Räumen bekannt. Dort ist beschrieben, daß bei derartigen Anlagen die Kapazität einer Elektrode gegen Erde oder gegen eine andere Elektrode gemessen und die zeitliche Kapazitätsänderung für eine Alarmgabe ausgewertet wird. Eine gleichmäßige Kapazitätsänderung, wie sie beispielsweise durch Bildung von Wassertropfen an den einzelnen Elektrodendrähten hervorgerufen wird, bringt dieser Anlage gegenüber herkömmlichen Anlagen gewisse Verbesserungen bezüglich der Störsicherheit. Eine Störung und damit eine Fehlalarmmeldung, wie sie beispielsweise durch das Aufsetzen eines Vogels auf einen Elektrodendraht hervorgerufen werden kann, läßt sich jedoch nicht vermeiden.

Aufgabe der Erfindung ist es daher, ein Meßverfahren und eine Vorrichtung für kapazitive Schutzzäune der obengenannten Art anzugeben, das bzw. die die Störsicherheit beträchtlich erhöht, ohne dabei die Alarmempfindlichkeit zu reduzieren.

Diese Aufgabe wird bezüglich des Verfahrens mit den kennzeichnenden Merkmalen des Anspruchs 1 und bezüglich der Vorrichtung mit den Merkmalen des Anspruchs 5 gelöst.

Mit diesem Verfahren werden jeweils die einzelnen Teilkapazitäten zwischen Sende- und Empfangselektroden und die einzelnen Eigenteilkapazitäten, das sind die Kapazitäten zwischen jeweils einer Elektrode und Erde, gemessen. Die Werte der in zeitlicher Reihenfolge gemessenen einzelnen Kapazitäten werden gespeichert, aus der zeitlichen Veränderung der Kapazitätswerte wird mit an sich bekannten Vergleichseinrichtungen und logischen Verknüpfungen ein Alarmkriterium abgeleitet. Diesem Verfahren liegen sowohl die Teilkapazitätsmessung als auch die Eigenteilkapazitätsmessung zugrunde, und deren Ergebnisse werden für die Alarmauswertung kombiniert. Damit kann die Redundanz der Alarmaussage und damit die Störsicherheit beträchtlich erhöht werden.

In vorteilhafter Weise wird man zur Messung der einzelnen Teilkapazitäten zwischen zwei benachbarten Elektroden eine Elektrode an den Sender, die andere Elektrode an den Empfänger schalten. Alle restlichen Elektroden werden, um nur die zu messende Kapazität zu erfassen, mit dafür vorgesehenen Schaltvorrichtungen an Erde geschaltet. Diese Anschaltung wird jeweils für ein Elektrodenpaar, vorgenommen, während die übrigen Elektroden geerdet sind. Die Werte der gemessenen Teilkapazitäten werden abgespeichert und ausgewertet.

Zur Messung der Eigenteilkapazität der einzelnen Elektroden wird man zweckmäßigerweise mittels Schaltvorrichtungen zeitlich nacheinander jeweils eine Elektrode niederohmig mit dem Sender verbinden und alle übrigen Elektroden direkt an den Sender schalten, der mit seinem zweiten Anschluß geerdet ist. Der zur Sendeelektrode fließende Strom kann beispielsweise mittels eines Übertragers gemessen und daraus die Eigenteilkapazität bestimmt werden. Ebenso wie bei der Teilkapazitätsmessung läßt sich auch hier aus den Änderungen der einzelnen Eigenteilkapazitäten bzw. aus dem zeitlichen Verlauf der einzelnen Eigenteilkapazitätsänderungen ein Alarmkriterium ableiten.

An Ausführungsbeispielen soll anhand von Zeichnungen das erfindungsgemäße Meßverfahren erläutert werden. Es zeigen

Figur 1  eine prinzipielle Schaltvorrichtung zur Teilkapazitätsmessung,

Figur 2  eine prinzipielle Schaltvorrichtung zur Eigenteilkapazitätsmessung und

Figur 3  ein Drei-Elektroden-System mit einer Kapazitäts-änderung (Störung) an einer Elektrode.

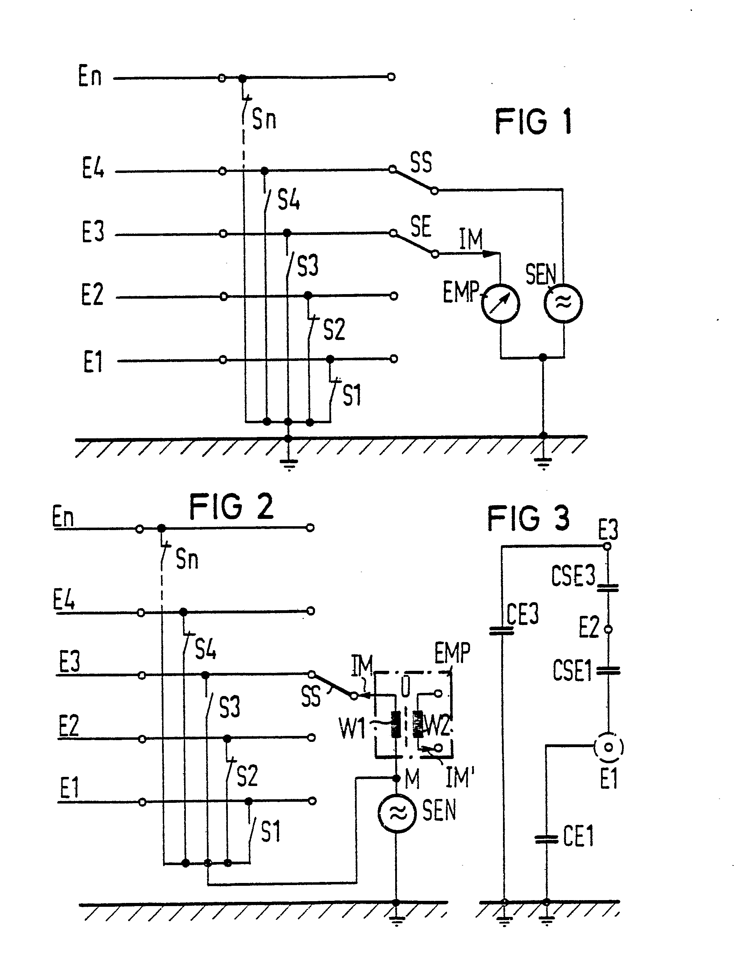

In Fig. 1 sind die Elektroden E1 bis En eines kapazitiven Schutzzaunes dargestellt. Mit einer ersten Schaltvorrichtung SS wird jeweils eine Elektrode, im Ausführungsbeispiel E4, an den Sender SEN geschaltet. Der Sender SEN ist mit seinem zweiten Anschluß geerdet. Mit einer zweiten Schaltvorrichtung SE wird jeweils eine andere Elektrode, hier Elektrode E3, an den Empfänger EMP geschaltet. Der Empfänger EMP ist mit seinem zweiten Anschluß ebenfalls geerdet. Alle übrigen Elektroden E1, E2, En sind mit jeweils weiteren Schaltvorrichtungen S1 bis Sn geerdet. Davon ausgenommen sind die Elektroden E3 bis E4, deren Schalter S3 und S4 geöffnet sind. Bei hinreichend kleinem Innenwiderstand von Sender SEN und Empfänger EMP ist der in den Empfänger EMP fließende Meßstrom IM proportional der Teilkapazität zwischen beiden gemessenen Elektroden. Die vom Empfänger EMP gemessene Teilkapazität zwischen Sendeelektrode E4 und Empfangselektrode E3 wird in einen Speicher übertragen, was hier aber nicht dargestellt ist. Hier soll nur das Grundprinzip veranschaulicht werden.

In Fig. 2 ist ein Schaltbeispiel zur Eigenteilkapazitätsmessung gezeigt. Es wird jeweils nur die Kapazität zwischen einer Elektrode und Erde gemessen. Dabei ist der Sender SEN einerseits geerdet und andererseits mit seinem Meßpotential M mittels einer Primärwicklung WI eines Übertragers Ü über die Schaltvorrichtung SS an eine zu messende Elektrode, z. B. E3, angeschlossen. Alle übrigen Elektrode E1 bis En, ausgenommen die Elektrode E3, sind mit weiteren Schaltvorrichtungen S1 bis Sn (S3 geöffnet) an Meßpotential M des Senders SEN gelegt. Der durch die Primärwicklung W1 des Übertragers Ü fließende Meßstrom IM ist bei hinreichend kleinem Innenwiderstand des Übertragers Ü der Eigenteilkapazität der gemessenen Elektrode proportional. An der Sekundärwicklung W2 des Übertragers Ü wird der induzierte Meßstrom IM' als Maß für die Eigenteilkapazität abgenommen und zur Weiterverarbeitung weitergeleitet, was hier nicht dargestellt und erläutert ist.

Eine an die Elektrode angeschlossene Meß- und Auswerteeinrichtung kann einen Mikrocomputer aufweisen, der ein zyklisches Anschalten der jeweiligen Elektroden an den Sender bzw. Empfänger, die Messung der einzelnen Teil- und Eigenteilkapazitäten nach den Schaltbeispielen der Fig. 1 und 2 und das Abspeichern der gemessenen Kapazitätswerte steuert und die Vergleiche und logischen Verknüpfungen der Meßwerte durchführt und daraus ein Alarmkriterium ableitet.

In Fig. 3 sind drei Elektroden dargestellt, von denen die erste und dritte Elektrode, E1 und E3, als Empfangselektrode und die mittlere Elektrode E2 als Senderelektrode betrieben werden. Es wird jeweils die Eigenteilkapazität und die Teilkapazität gemessen. Zwischen der Elektrode E1 und Erde wird die Eigenteilkapazität CE1, zwischen der Elektrode E3 und Erde wird die Eigenteilkapazität CE3 gemessen. Zwischen der Sendeelektrode E2 und der Empfangselektrode E1 wird die Teilkapazität CSE1 und zwischen der Sendeelektrode E2 und der Empfangselektrode E3 wird die Teilkapazität CSE3 gemessen. Es sei nun angenommen, daß eine Störung durch beispielsweise einen auf der Elektrode E1 aufsitzenden Vogel verursacht wird. Dies führt zu einer Elektrodenverdickung (mit einem gestrichelten Kreis dargestellt) der Elektrode E1, darf aber keinen Alarm auslösen. Die Teilkapazität CSE1 zwischen Empfangselektrode E1 und Sendeelektrode E2 vergrößert sich, während die Teilkapazität CSE3 zwischen der Empfangselektrode E3 und der Sendeelektrode E2 annähernd unverändert bleibt. Ebenso verhält es sich bei den Eigenteilkapazitäten. Die Eigenteilkapazität CE3 bleibt etwa konstant, während sich die Eigenteilkapazität CE1 vergrößert.

Ein sich dem Schutzzaun nähernder Eindringling würde beide Teil- bzw. Eigenteilkapazitäten verändern. Ein bekanntes Auswerteverfahren, das nur den Absolutwert der Differenz der Teilkapazitäten (CSE1-CSE3) bewertet, würde einen Alarm auslösen, weil mit den bekannten Meßverfahren nicht unterschieden werden kann, ob ein Eindringling (Alarm) oder nur Verdickung einer Elektrode (Störung !) vorliegt. Es ändert sich in beiden Fällen, sowohl bei der Teilkapazitäts- als auch bei der Eigenteilkapazitätsmessung, die resultierende Kapazitätsdifferenz.

Mit dem erfindungsgemäßen Meßverfahren kann hingegen jeweils die Teil- und die Eigenteilkapazität einzeln gemessen und ausgewertet werden. Daraus resultiert in diesem betrachteten Fall, daß die Kapazitätsänderung eindeutig der ersten Elektrode E1 zuzuordnen ist und somit eine Störung und kein Alarm vorliegt. Damit ergibt sich aufgrund der Einzelkapazitätsmessung eine erhöhte Störsicherheit. Werden die Teil- und Eigenteilkapazitätsmessung gemäß den beiden Schaltungsanordnungen bewertet, miteinander verknüpft und verglichen, so ist eine hohe Störsicherheit gegeben. Betrachtet man zudem die Zeitverläufe der einzelnen Kapazitätsänderungen und wertet diese aus, so läßt sich die Störsicherheit noch weiter erhöhen, denn für einen Eindringling gibt es charakteristische Zeitkapazitätsverläufe, die sich gegenüber den Zeitverläufen von Störungen gravierend unterscheiden.

**Patentansprüche**

1. Verfahren zur Messung der Kapazitäten an einem kapazitiven Schutzzaun, wobei von einer Zentrale aus die einzelnen Teilkapazitäten zwischen den Elektroden oder die einzelnen Eigenteilkapazitäten zwischen einer Elektrode und Erde gemessen und die Zeitverläufe der einzelnen Kapazitätsänderungen ausgewertet werden und wobei daraus ein Alarmkriterium zur Ansteuerung einer auf Kapazitätsänderungen ansprechenden Alarmeinrichtung abgeleitet wird, dadurch gekennzeichnet, daß sowohl die einzelnen Teilkapazitäten (CSE1, ...) zwischen den Elektroden (E1, E2, ...) als auch die einzelnen Eigenteilkapazitäten (CE1, CE2, ...) zwischen einer Elektrode (E1, E2, ...) und Erde gemessen und die Zeitverläufe der einzelnen Kapazitätsänderungen gespeichert werden und aus der logischen Verknüpfung der einzelnen Kapazitätsänderungen ein Alarmsignal abgeleitet wird.

2. Verfahren nach Anspruch 1, dadurch gekennzeichnet, daß zur Messung der einzelnen Teilkapazitäten (CSE) zwischen zwei Elektroden (E3 und E4) eine Elektrode (E4) an einen Sender (SEN), eine andere Elektrode (E3) an einen Empfänger (EMP) einer Meßeinrichtung und alle anderen Elektroden (E1, E2, En) auf Erdpotential geschaltet werden.

3. Verfahren nach Anspruch 1, dadurch gekennzeichnet, daß zur Messung der einzelnen Eigenteilkapazitäten zwischen einer Elektrode (E3) und Erde die Elektrode (E3) niederohmig (EMP bzw. W1) an einen Sender (SEN) und alle anderen Elektroden (E1, E2, E4, En) direkt an den Sender (SEN) einer Meßeinrichtung geschaltet werden.

4. Verfahren nach einem der Ansprüche 1 bis 3, dadurch gekennzeichnet, daß die einzelnen Teil- und Eigenteilkapazitäten (CSE ; CE) der Reihe nach gemessen und zur Auswertung einem Mikrocomputer zugeführt werden, wobei der Mikrocomputer die Steuerung der Kapazitätsmessungen, das Speichern der gemessenen Kapazitätswerte, das Auswerten der Zeitverläufe der einzelnen Kapazitätsänderungen und das Weiterleiten der Daten übernimmt.

5. Vorrichtung zur Durchführung des Verfahrens nach Anspruch 1, dadurch gekennzeichnet, daß ein Sender (SEN), ein Empfänger (EMP) und Schaltvorrichtungen (SS, SE, S1 bis Sn) vorgesehen sind, mit denen wahlweise die Elektroden (E1 bis En) an den Sender (SEN), an den Empfänger (EMP) und auf Erdpotential (EMP) schaltbar sind, wobei zur Teilkapazitätsmessung der Sender (SEN) und der Empfänger (EMP) mit jeweils einem ersten Anschluß auf Erdpotential liegen und wobei mit einer ersten Schaltvorrichtung (SS) der zweite Anschluß des Senders jeweils an eine Elektrode (E1 bis En ; z. B. E4) anschaltbar ist, mit einer zweiten Schaltvorrichtung (SE) der zweite Anschluß des Empfängers (EMP) jeweils an eine Elektrode (E1 bis En ; z. B. E3) anschaltbar ist, und mit weiteren Schaltvorrichtungen (S1 bis Sn) die nicht beschalteten Elektroden (z. B. E1, E2, En) auf Erdpotential schaltbar sind, und wobei ferner zur Eigenteilkapazitätsmessung der Sender (SEN) und der Empfänger (EMP bzw. W1) mit jeweils einem Anschluß gemeinsam auf Meßpotential (M) liegen, der Sender (SEN) mit seinem zweiten Anschluß auf Erdpotential liegt, der Empfänger (EMP bzw. W1) mit einer ersten Schaltvorrichtung (SS) jeweils an eine Elektrode (z. B. E3) anschaltbar ist und mit weiteren Schaltvorrichtungen (S1 bis Sn) die nicht beschalteten Elektroden (E1, E2, E4, En) auf Meßpotential (M) schaltbar sind.

## Claims

1. A method of measuring the capacitances of a capacitive protective fence, wherein the individual subsidiary capacitances between the electrodes or the individual subsidiary self-capacitances between one electrode and earth are measured from a central control, the time curves of the individual capacitance changes are analysed, and an alarm criterion formed to drive an alarm device which responds to capacitance changes, characterised in that both the individual subsidiary capacitances (CSE1...) between the electrodes (E1, E2, ...) and the individual subsidiary self-capacitances (CE1, CE2, ...) between one electrode (E1, E2, ...) and earth are measured, the time curves of the individual capacitance changes are stored, and an alarm signal is derived from the logic link between the individual capacitance changes.

2. A method as claimed in Claim 1, characterised in that for the measurement of the individual subsidiary capacitances (CSE) between two electrodes (E3 and E4), an electrode (E4) is connected to a transmitter (SEN) and another electrode (E3) is connected to a receiver (EMP) of a measuring device, and all the other electrodes (E1, E2, En) are connected to earth potential.

3. A method as claimed in Claim 1, characterised in that for the measurement of the individual subsidiary self-capacitances between an electrode (E3) and earth, the electrode (E3) is connected in low-ohmic fashion (EMP and W1) to a measuring device transmitter (SEN), and all the other electrodes (E1, E2, E4, En) are directly connected to the transmitter (SEN).

4. A method as claimed in one of Claims 1 to 3, characterised in that the individual subsidiary capacitances and subsidiary self-capacitances (CSE : CE) are measured in turn and are fed to a microcomputer for analysis, where the microcomputer undertakes the control of the capacitance measurements, the storage of the measured capacitance values, the analysis of the time curves of the individual capacitance changes and the forwarding of the data.

5. A device for the implementation of the method as claimed in Claim 1, characterised in that a transmitter (SEN), a receiver (EMP) and switching devices (SS, SE, S1 to Sn) are provided, by which the electrodes (E1 to En) can be selectively connected to the transmitter (SEN), to the receiver (EMP) and to earth potential (EMP), where for the measurement of the subsidiary capacitances the transmitter (SEN) and the receiver (EMP) are each connected by a first terminal to earth potential, and where, by means of a first switching device (SS) the second terminal of the transmitter can in each case be connected to an electrode (E1 to En ; e. g. E4), the second terminal of the receiver (EMP) can in each case be connected to an electrode (E1 to En ; e. g. E3) by means of a second switching device (SE), and the non-connected electrodes (e.g. E1, E2, En) can be connected to earth potential by means of further switching devices (S1 to Sn), and moreover to measure the subsidiary self-capacitances the transmitter (SEN) and the receiver (EMP and W1) are each commonly connected by one terminal to measuring potential (M), the transmitter (SEN) is connected by its second terminal to earth potential, the receiver (EMP and W1) can be connected by a first switching device (SS) to an electrode (e. g. E3) and by means of further switching devices (S1 to Sn) the non-connected electrodes (E1, E2, E4, En) can be connected to measuring potential (M).

## Revendications

1. Procédé pour mesurer les capacités sur une clôture de protection capacitive, selon lequel on mesure depuis une centrale les différentes capacités partielles entre les électrodes ou les différentes capacités partielles propres entre une électrode et la terre, on évalue les durées des différentes variations de capacité et on en tire un critère d'alarme pour attaquer un appareil d'alarme sensible aux variations de capacité, caractérisé en ce que l'on mesure aussi bien les différentes capacités partielles (CSE1, ...) entre les électrodes (E1, E2, ...) que les différentes capacités partielles propres (CE1, CE2, ...) entre une électrode (E1, E2, ...) et la terre, on mémorise les durées des différentes variations de capacité et on tire un signal d'alarme de la combinaison logique des différentes variations de capacité.

2. Procédé selon la revendication 1, caractérisé en ce que, pour mesurer les différentes capacités partielles (CSE) entre deux électrodes (E3 et E4), on relie une électrode (E4) à un émetteur (SEN) et une autre électrode (E3) à un récepteur (EMP) d'un appareil de mesure et on relie toutes les autres électrodes au potentiel de la terre.

3. Procédé selon la revendication 1, caractérisé en ce que, pour mesurer les différentes capacités partielles propres entre une électrode (E3) et la terre, on relie l'électrode (E3) par une connexion à faible valeur ohmique (EMP ou W1) à un émetteur (SEN) et on relie toutes les autres électrodes (E1, E2, E4, En) directement à l'émetteur (SEN) d'un appareil de mesure.

4. Procédé selon une des revendications 1 à 3, caractérisé en ce que l'on mesure les différentes capacités partielles et les différentes capacités partielles propres (CSE ; CE) l'une après l'autre, et on les applique pour l'évaluation à un micro-ordinateur, lequel assure la commande des mesures de capacité, la mémorisation des valeurs de capacité mesurées, l'évaluation des durées des différentes variations de capacité et la transmission des données.

5. Dispositif pour la mise en œuvre du procédé selon la revendication 1, caractérisé en ce qu'il comprend un émetteur (SEN), un récepteur (EMP) et des dispositifs de commutation (SS, SE, S1 à Sn), au moyen desquels les électrodes (E1 à Sn) peuvent être reliées sélectivement à l'émetteur (SEN), au récepteur (EMP) et au potentiel de la terre (EMP), où, pour la mesure de la capacité partielle, l'émetteur (SEN) et le récepteur (EMP) sont reliés chacun par une première borne au potentiel de la terre, la deuxième borne de l'émetteur peut être reliée chaque fois à une électrode (E1 à En ; E4 par exemple) par un premier dispositif de commutation (SS), la deuxième borne du récepteur (EMP) peut être reliée chaque fois à une électrode (E1 à En ; E3 par exemple) par un second dispositif de commutation (SE) et les autres électrodes (E1, E2, En par exemple) peuvent être reliées au potentiel de la terre par d'autres dispositifs de commutation (S1 à Sn), et où, en outre, pour la mesure de la capacité partielle propre, l'émetteur (SEN) et le récepteur (EMP ou W1) sont conjointement reliés par une borne au potentiel de mesure (M), l'émetteur (SEN) est relié par sa deuxième borne au potentiel de la terre, le récepteur (EMP ou W1) peut être relié chaque fois à une électrode (E3 par exemple) par un premier dispositif de commutation (SS) et les autres électrodes peuvent être reliées au potentiel de mesure (M) par d'autres dispositifs de commutation (S1 à Sn).

FIG 1

FIG 2

FIG 3